# FASCICULE DE BREVET EUROPEEN

(11) **EP 4 264 290 B1**
(45) Date de publication et mention de la délivrance du brevet: **03.12.2025**
(21) Numéro de dépôt: 21854932.7
(22) Date de dépôt: 17.12.2021
(51) Int. Cl.: G01R 15/18, G01R 31/08, G01R 31/58, H04B 3/54

(54) **SURVEILLANCE D'UNE LIGNE DE TRANSMISSION**
ÜBERWACHUNG EINER ÜBERTRAGUNGSLEITUNG
MONITORING OF A TRANSMISSION LINE

(30) Priorité: 21.12.2020 FR 2013812
(43) Date de publication de la demande: 25.10.2023
(73) Titulaire: Safran Electronics & Defense, 75015 Paris (FR)
(72) Inventeur: GUILLOT, François, 77550 MOISSY-CRAMAYEL (FR); CHETANNEAU, Patrice, 77550 MOISSY-CRAMAYEL (FR)
(74) Mandataire: Gevers & Orès
(86) Numéro de dépôt international: PCT/FR2021/052396
(87) Numéro de publication internationale: WO 2022/136783

(56) Documents cités:
- EP-A1- 1 316 134
- EP-A2- 1 889 377
- EP-B1- 1 316 134
- EP-B1- 1 889 377
- FR-A1- 2 930 041
- FR-A1- 3 083 321
- JP-A- 2014 130 061
- US-A1- 2020 185 902
- US-B1- 6 984 979
- US-B2- 10 203 363

## Description

### Domaine technique de l'invention

La présente invention concerne la surveillance d'une ligne de transmission. Plus précisément, elle concerne un système de surveillance d'une ligne de transmission, un système de distribution électrique comportant un tel système de surveillance, un aéronef comportant un tel système de distribution, un procédé de surveillance d'une ligne de transmission et un programme d'ordinateur correspondant.

### Arrière-plan technologique

Les documents FR 3 083 321 A1 et FR 3 083 365 A1 décrivent chacun un système de surveillance d'une ligne de transmission, du type comportant :
- un dispositif de couplage connecté à la ligne de transmission pour recevoir un courant de la ligne de transmission ;
- un dispositif de traitement de données connecté au dispositif de couplage et conçu pour :
   - fournir un signal d'excitation au dispositif de couplage pour qu'un signal interne apparaisse dans le dispositif de couplage, ce signal interne présentant une déformation résultant du courant à mesurer,
   - obtenir un signal de mesure d'une grandeur du dispositif de couplage sensible à la déformation du signal interne,
   - fournir un signal de compensation au dispositif de couplage à partir du signal de mesure pour annuler la déformation ; et
   - évaluer le courant à mesurer à partir du signal de compensation.

Plus précisément, dans ces documents, le système de surveillance comporte un capteur de courant à vanne de flux.

Les documents US 2020/185902 A1, FR 2 930 041 A1, US 10 203 363 B2, US 6,984,979 B1 et JP 2014 13006 A décrivent également des capteurs de courant à vanne de flux. Par ailleurs, les documents EP 1 316 164 et EP 1 889 377 concernent la transmission de données sur une ligne.

Il peut être souhaité de prévoir un système de surveillance d'une ligne de transmission qui permette une meilleure surveillance sans multiplier les dispositifs de mesure.

### Résumé de l'invention

Il est donc proposé un système de surveillance d'une ligne de transmission, du type précité caractérisé en ce que, le signal de mesure étant en outre sensible à la présence d'un défaut sur la ligne de transmission, le dispositif de traitement de données est en outre conçu pour analyser le signal de mesure et pour détecter, à partir de cette analyse, un défaut sur la ligne de transmission.

Ainsi, le système de surveillance selon l'invention permet, en plus de la mesure du courant de la ligne de transmission, de détecter un défaut sur la ligne de transmission en utilisant les éléments déjà présents pour la mesure de courant.

De façon optionnelle, le dispositif de couplage comporte un transformateur avec un noyau ferromagnétique, le signal interne étant un flux magnétique total présent dans le noyau et regroupant un flux magnétique d'excitation résultant du signal d'excitation, un flux magnétique de courant résultant du courant à mesurer et un flux magnétique de compensation résultant du signal de compensation de manière à sensiblement annuler le flux magnétique de courant.

De façon optionnelle également, l'analyse du signal de mesure comporte de comparer le signal de mesure avec au moins un gabarit et la détection du défaut sur la ligne de transmission est réalisée à partir d'instants où le signal de mesure est en dehors d'au moins un parmi le ou les gabarits.

De façon optionnelle également, le signal d'excitation comporte un signal oscillant.

De façon optionnelle également, le signal oscillant comporte une somme d'une sinusoïde à une fréquence fondamentale et d'une sinusoïde au troisième harmonique, c'est-à-dire à trois fois la fréquence fondamentale.

De façon optionnelle également, le signal d'excitation générant, au travers du dispositif de couplage, un signal se propageant sur la ligne de transmission, le dispositif de traitement de données est en outre conçu pour coder des données à transmettre en un signal codé et le signal d'excitation comporte le signal codé afin que le signal se propageant inclut les données à transmettre.

De façon optionnelle également, le signal codé est de moyenne nulle.

De façon optionnelle également, le signal codé présente une fréquence fondamentale plus élevée que celle du signal oscillant.

De façon optionnelle également, le au moins un gabarit comporte un gabarit global qui suit, d'une part, des variations d'un signal oscillant du signal de mesure résultant du signal oscillant du signal d'excitation et, d'autre part, une enveloppe d'un signal codé du signal de mesure résultant du signal codé du signal d'excitation.

De façon optionnelle également, le au moins un gabarit comporte un gabarit local suivant des variations d'un signal codé du signal de mesure résultant du signal codé du signal d'excitation.

De façon optionnelle également, le signal oscillant comporte une suite de montées et de descentes et dans lequel le signal codé n'est présent que sur l'un parmi les montés et les descentes.

De façon optionnelle également, le signal de mesure comporte une suite de montées et de descentes correspondant respectivement aux montées et descentes du signal oscillant et dans lequel le dispositif de traitement de données est en outre conçu pour décoder un signal codé présent sur l'autre parmi les montées et les descentes du signal de mesure.

De façon optionnelle également, la ligne de transmission est un câble coaxial.

Il est également proposé un système de distribution électrique comportant :
- une source électrique ;
- une charge électrique ;
- une ligne à transmission connectant la charge électrique à la source électrique, afin que la source électrique alimente électriquement la charge électrique ;
- un système de surveillance de la ligne à transmission, selon l'invention.

De façon optionnelle, la source électrique est une source de tension continue, de préférence supérieure à 100 V.

Il est également proposé un aéronef comportant un système de distribution électrique selon l'invention.

Il est également proposé un procédé de surveillance d'une ligne à transmission, utilisant un dispositif de couplage connecté à la ligne de transmission pour recevoir un courant de la ligne de transmission, comportant :
- fournir un signal d'excitation au dispositif de couplage pour qu'un signal interne apparaisse dans le dispositif de couplage, ce signal interne présentant une déformation résultant du courant à mesurer,
- obtenir un signal de mesure d'une grandeur du dispositif de couplage sensible à la déformation du signal interne,
- fournir un signal de compensation au dispositif de couplage à partir du signal de mesure pour annuler la déformation ; et
- évaluer le courant à mesurer à partir du signal de compensation ;
caractérisé en ce que, le signal de mesure étant en outre sensible à la présence d'un défaut sur la ligne de transmission, le procédé comporte en outre l'analyse le signal de mesure et la détection, à partir de cette analyse, d'un défaut sur la ligne de transmission.

Il est également proposé un programme d'ordinateur téléchargeable depuis un réseau de communication et/ou enregistré sur un support lisible par ordinateur, caractérisé en ce qu'il comprend des instructions pour l'exécution des étapes d'un procédé selon l'invention, lorsque ledit programme est exécuté sur un ordinateur

### Brève description des figures

L'invention sera mieux comprise à l'aide de la description qui va suivre, donnée uniquement à titre d'exemple et faite en se référant aux dessins annexés dans lesquels :
[Fig. 1] la figure 1 est une vue schématique d'un système de distribution électrique mettant en œuvre l'invention, ce système de distribution électrique comportant une ligne de transmission,
[Fig. 2] la figure 2 est une vue schématique d'un système de surveillance de la ligne de transmission de la figure 1,
[Fig. 3] la figure 3 est un graphe illustrant une saturation d'un flux magnétique dans un noyau ferromagnétique,
[Fig. 4] la figure 4 illustre la somme de signaux pour former un signal d'excitation,
[Fig. 5] la figure 5 illustre un signal mesuré par le système de surveillance,
[Fig. 6] la figure 6 illustre un premier gabarit entourant le signal mesuré par le système de surveillance,
[Fig. 7] la figure 7 illustre un deuxième gabarit entourant le signal mesuré par le système de surveillance,
[Fig. 8] la figure 8 illustre une déformation du signal mesuré résultant d'un premier défaut de la ligne de transmission,

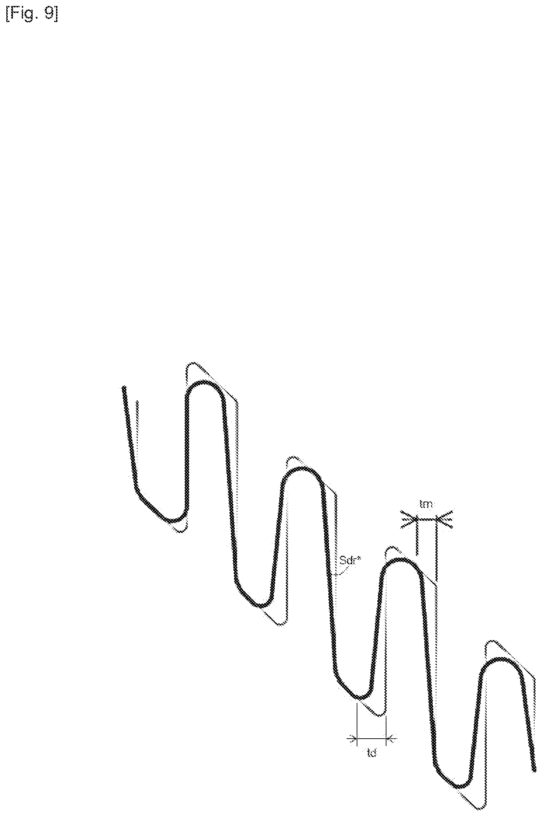

[Fig. 9] la figure 9 illustre une déformation du signal mesuré résultant d'un deuxième défaut de la ligne de transmission, et
[Fig. 10] la figure 10 est une vue schématique d'un système de surveillance de la ligne de transmission de la figure 1, selon un autre mode de réalisation.

### Description détaillée de l'invention

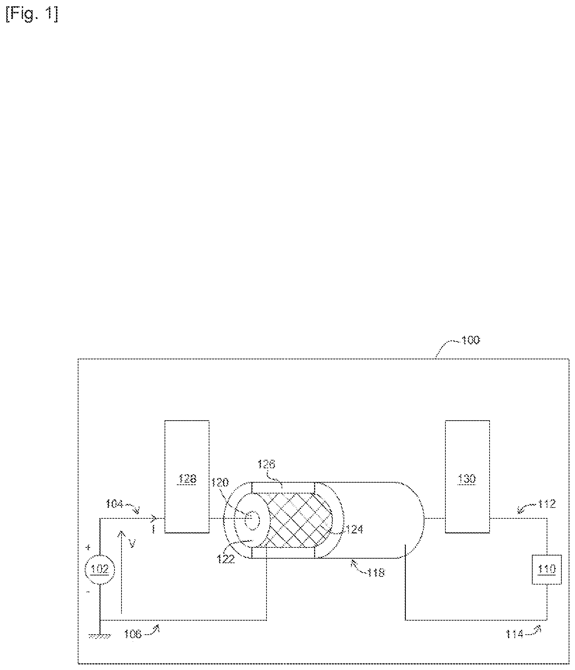

En référence à la figure 1, un exemple de système 100 de distribution électrique mettant en œuvre l'invention va à présent être décrit.

Dans l'exemple décrit, le système de distribution électrique 100 est destiné à être mis en œuvre dans un aéronef.

Le système 100 comporte tout d'abord une source électrique 102 conçu pour fournir une tension continue V. De préférence, la tension continue V est une haute tension, par exemple d'au moins 100 V, de préférence encore d'au moins 1 000 V. La source électrique 102 comporte ainsi une borne positive « + » et une borne négative « - » entre lesquelles la tension continue V est fournie. La source électrique 102 est par exemple conçue pour fournir une puissance électrique d'au moins 100 kW. La source électrique 102 comporte par exemple un ou plusieurs parmi : une batterie, un alternateur entrainé par une turbine (moteur ou générateur auxiliaire), une pile à combustible et un super condensateur.

Le système 100 comporte en outre une première connexion positive 104 et une première connexion négative 106, connectées respectivement à la borne positive et à la borne négative de la source de tension 102.

Le système 100 comporte en outre une charge électrique 110 destinée à être alimentée électriquement par la source électrique 102. L'aéronef 100 comporte des deuxièmes connexions positive 112 et négative 114, connectées respectivement à deux bornes de la charge électrique 110. La charge électrique 110 comporte par exemple un ou plusieurs parmi : un moteur électrique de propulsion, un moteur électrique d'actionnement de train d'atterrissage ou de commande de vol et une résistance chauffante de dégivrage.

Pour transmettre de l'énergie électrique de la source électrique 102 à la charge électrique, l'aéronef 100 comporte en outre une ligne de transmission connectant, d'une part, les deux connexions positives 104, 112 l'une à l'autre et, d'autre part, les deux connexions négatives 106, 114 l'une à l'autre.

De préférence, la ligne de transmission est un câble coaxial 118. Ce câble coaxial 118 comporte tout d'abord une âme centrale 120 conductrice, et une première gaine diélectrique 122, dite interne, entourant l'âme centrale 120. Le câble coaxial 118 comporte en outre un blindage 124 entourant la première gaine diélectrique 122. Le blindage 124 est par exemple sous la forme d'un grillage cylindrique. Le câble coaxial 118 comporte en outre une deuxième gaine diélectrique 126, dite externe, entourant le blindage 124.

Les connexions positives 104, 112 sont ainsi connectées l'une à l'autre par l'âme centrale 120, tandis que les connexions négatives 106, 114 sont connectées l'une à l'autre par le blindage 124. Ainsi, l'âme centrale 120 achemine un courant d'alimentation I de la source électrique 102 à la charge électrique 110, tandis que le blindage 124, qui est conducteur, est utilisé comme ligne de retour de courant depuis la charge électrique 110 jusqu'à la source électrique 102.

Le câble coaxial 118 présente en particulier l'avantage de posséder une impédance itérative, c'est-à-dire que les propriétés électriques du câble coaxial restent sensiblement constantes sur toute sa longueur. D'autres types de ligne de transmission pourraient également posséder cette propriété. En outre, le câble coaxial 118 présente comme avantage que le blindage 124 qui est au potentiel bas, entoure l'âme centrale 120 qui est au potentiel haut. Ainsi, en cas de dégradation du câble coaxial 118, c'est le blindage 124 qui devient apparent en premier. Or, du fait qu'il est au potentiel bas, les personnes touchant le blindage courent peu de risques. Plus précisément, ce potentiel bas peut être très proche du potentiel de la structure de l'aéronef (par exemple, moins de 10 V). Dans ces conditions, le risque d'électrocution est sensiblement nul.

Une telle ligne de transmission peut ainsi être facilement utilisée dans un aéronef ayant une structure en matériaux composites, qui sont isolants électriques et ne peuvent de ce fait jouer le rôle de masse électrique formant une ligne de retour de courant.

Le système 100 comporte en outre des premier et deuxième systèmes 128, 130 de surveillance de la ligne de transmission 118 respectivement agencés sur les première et deuxième connexions positives 104, 112.

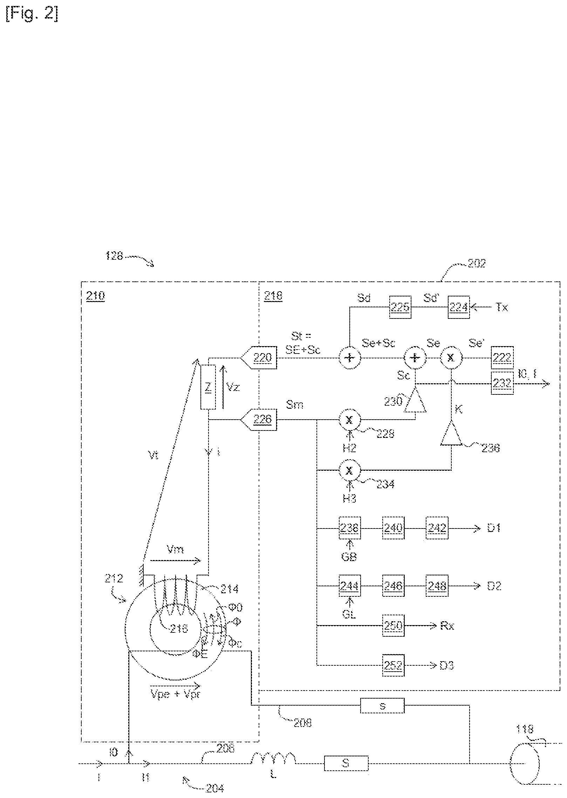

En référence à la figure 2, un exemple de mise en œuvre du système de surveillance 128 va à présent être décrit, le système de surveillance 130 étant par exemple similaire au système de surveillance 128.

Le système de surveillance 128 comporte tout d'abord un capteur de courant 202 à vanne de flux.

Le capteur de courant 202 est conçu pour mesurer le courant d'alimentation I. Comme ce dernier peut être très élevé, le capteur de courant 202 comporte tout d'abord, dans l'exemple décrit, un diviseur de courant 204 comportant, d'une part, une branche principale 206 dans laquelle une majeure partie I1 du courant d'alimentation I est destinée à passer et, d'autre part, une branche auxiliaire 208 dans laquelle une petite partie I0 du courant d'alimentation I, appelée courant auxiliaire I0, est destinée à passer. La branche principale 206 présente une résistance S, tandis que la branche auxiliaire présente une résistance s, beaucoup plus petite que la résistance S. En outre, une inductance L est prévue sur la branche principale 206.

Le courant auxiliaire I0 et le courant d'alimentation I présentent un rapport généralement connu et fixe. Ainsi, une mesure du courant auxiliaire I0 permet d'en déduire le courant d'alimentation I.

Le capteur de courant 202 comporte en outre un dispositif de couplage 210 connecté à la ligne de transmission 118 pour recevoir le courant auxiliaire I0 de la ligne de transmission 118.

Dans l'exemple décrit, le dispositif de couplage 210 comporte tout d'abord un transformateur 212 comportant un noyau ferromagnétique 214 en boucle fermée, dans lequel passe la branche auxiliaire 208 afin de former un primaire du transformateur 212.

Le transformateur 212 comporte en outre une bobine 216 enroulée autour du noyau 214 et formant un secondaire du transformateur 212. Cette bobine 216 présente deux extrémités, dont une première est connectée à une masse électrique.

Le dispositif de couplage 210 comporte en outre une impédance Z, par exemple une résistance, qui dans l'exemple illustré sur la figure 2 est connectée à une deuxième extrémité de la bobine 216.

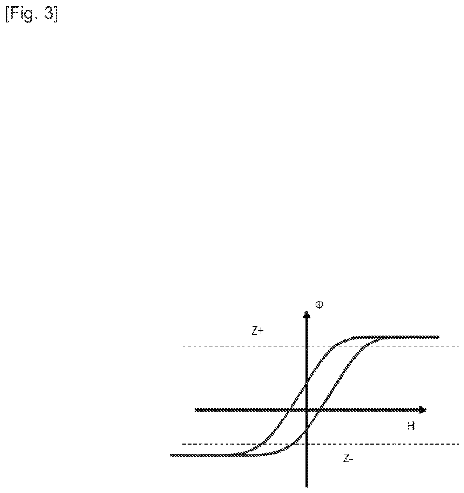

La figure 3 illustre l'évolution d'un flux magnétique total Φ dans le noyau 214 en fonction d'une excitation H de ce noyau 214. Comme cela est visible, cette évolution présente deux zones de saturation du flux magnétique total Φ : une zone de saturation, dite positive Z+, lorsque le flux magnétique total Φ devient très grand positivement et une zone de saturation, dite négative Z-, lorsque le flux magnétique total Φ devient très grand négativement. Dans chaque zone de saturation Z+, Z-, le flux magnétique total Φ augmente de moins en moins (positivement ou négativement suivant la zone) malgré une excitation H de plus en plus forte. Au contraire, entre les zones de saturation Z+, Z-, le flux magnétique total Φ évolue sensiblement linéairement (en négligeant le phénomène d'hystérésis) en fonction de l'excitation H.

De retour à la figure 2, lorsque le courant auxiliaire I0 est non nul, il provoque l'apparition d'un flux magnétique de courant Φ0 dans le noyau 214. Généralement, le courant d'alimentation I est relativement constant, de même que le courant auxiliaire I0. Ainsi, le flux magnétique de courant Φ0 est également relativement constant.

Le capteur de courant 202 comporte en outre un dispositif de traitement de données 218 conçu pour utiliser le dispositif de couplage 210 pour mesurer le courant auxiliaire I0, et donc le courant d'alimentation I.

Le dispositif 218 est par exemple un système informatique comportant une unité de traitement de données (telle qu'un microprocesseur) et une mémoire principale (telle qu'une mémoire RAM, de l'anglais « Random Access Memory ») accessible par l'unité de traitement. Le système informatique comporte en outre de préférence d'une mémoire non-volatile telle qu'une EEPROM (de l'anglais « Electrically Erasable Programmable Read Only Memory », une PROM-Flash (« Programmable Read Only Memory Flash »), M-RAM (de l'anglais « Magnetoresistive Random-Access Memory ») ou toute autre technologie de mémoire fonctionnelle hors tension, pour l'enregistrement des données. Un programme d'ordinateur contenant des instructions pour l'unité de traitement est par exemple destiné à être chargé dans la mémoire principale, afin que l'unité de traitement exécute ses instructions pour réaliser les fonctions et les modules du dispositif 218 qui vont être décrites.

Alternativement, tout ou partie de ces fonctions et modules pourrait être implémenté sous forme de modules matériels, c'est-à-dire sous forme d'un circuit électronique, par exemple micro-câblé, ne faisant pas intervenir de programme d'ordinateur. Il peut par exemple s'agir d'un circuit logique programmable, tel qu'un réseau de portes programmables in situ, généralement désigné par l'acronyme FPGA (de l'anglais « Field-Programmable Gate Array »).

Le dispositif 218 est tout d'abord conçu pour fournir un signal d'excitation SE au dispositif de couplage 210 pour générer, avec le courant auxiliaire I0, un flux magnétique total Φ qui, en l'absence de la compensation qui sera décrite plus loin, présente une déformation résultant du flux magnétique de courant Φ0 provenant du courant à mesurer I0.

Plus précisément, le signal d'excitation SE provoque l'apparition d'un flux magnétique d'excitation ΦE auquel s'ajoute le flux magnétique de courant Φ0. Le flux magnétique d'excitation ΦE est destiné à osciller entre un maximum et un minimum atteignant respectivement les zones de saturation Z+, Z-. Or, à cause du flux magnétique de courant Φ0, le flux magnétique total Φ (ΦE + Φ0) est décalé vers l'une des deux zones de saturation Z+, Z- (suivant le signe du courant auxiliaire I0) et est donc déformé par rapport au cas où le courant auxiliaire I0 (et donc le flux magnétique de courant Φ0) est nul. En effet, dans ce dernier cas, la saturation est sensiblement identique pour les maximum et les minimum, tandis qu'avec le courant auxiliaire I0, l'un parmi les maximum et les minimum est plus saturé que l'autre.

Le dispositif 218 est en outre conçu pour fournir un signal de compensation Sc au dispositif de couplage 210 pour qu'un flux magnétique de compensation Φc résultant annule sensiblement le flux magnétique de courant Φ0.

Dans l'exemple décrit où une seule bobine 216 est utilisée, ces deux signaux SE, Sc sont additionnés en un seul signal total, noté St.

Pour que ce signal total St produise l'apparition des flux d'excitation ΦE et de compensation Φc, le dispositif 218 comporte, dans l'exemple décrit, un convertisseur numérique-analogique 220 pour convertir le signal total St en une tension Vt appliquée aux bornes de l'impédance Z et de la bobine 216. Ainsi, la tension Vt génère un courant i parcourant l'impédance Z et la bobine 216, de manière à générer une excitation dans le noyau 214.

Pour générer le signal d'excitation SE, le dispositif 218 comporte, dans l'exemple décrit, un module 222 de génération d'un signal oscillant initial Se'. Le signal oscillant initial Se' est par exemple formé de préférence d'au moins une sinusoïde à une fréquence fondamentale et une sinusoïde au troisième harmonique, c'est-à-dire trois fois la fréquence fondamentale. Par exemple, le signal oscillant initial est composé uniquement de ces deux sinusoïdes. Alternativement, le signal oscillant initial Se' pourrait être un signal triangulaire comportant une sinusoïde à une fréquence fondamentale et des sinusoïdes aux harmoniques impairs de cette fréquence fondamentale, dont en particulier une sinusoïde au troisième harmonique.

Pour s'assurer que les zones de saturation Z+, Z- sont bien atteintes, le dispositif 218 est en outre conçu, toujours dans l'exemple décrit, pour multiplier le signal oscillant initial Se' par un coefficient d'asservissement de saturation K, afin d'obtenir un signal oscillant Se. Ainsi, le signal oscillant Se comporte, comme le signal oscillant Se', une sinusoïde à la fréquence fondamentale et une sinusoïde au troisième harmonique. Une manière de calculer ce coefficient K sera détaillée plus loin.

Le dispositif 218 comporte en outre un module de codage 224 conçu pour coder des données à transmettre Tx en un signal codé initial Sd' et un intégrateur 225 conçu pour intégrer le signal codé inital Sd' en un signal codé Sd. Le dispositif 218 est alors conçu pour sommer le signal codé Sd avec le signal oscillant Se pour former le signal d'excitation SE.

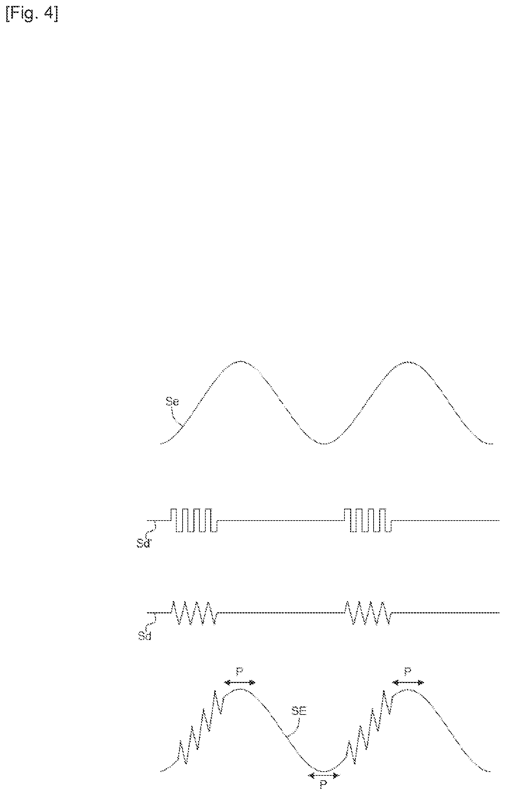

La figure 4 illustre un exemple de signal oscillant Se, de signal codé initial Sd', de signal codé Sd, ainsi que leur somme SE.

De préférence, le signal codé initial Sd' intègre un signal d'horloge. En effet, cela facilite la récupération du rythme du message et donc la récupération des données.

De préférence encore, le signal codé initial Sd' est de moyenne nulle, et donc également le signal codé Sd. Ainsi, la portion du flux magnétique d'excitation ΦE issue du signal codé est également de moyenne nulle, de manière à ne pas fausser la mesure de courant, comme cela sera expliqué par la suite.

De préférence encore, le signal codé initial Sd' est un signal en créneaux. En effet, l'utilisation de créneaux est une manière simple de représenter des données binaires. Ces créneaux sont convertis par l'intégrateur 225 en dents de scie (c'est-à-dire un signal triangulaire).

Par exemple, le codage Manchester Bi-phase est utilisé, ce codage regroupant les trois caractéristiques précédentes.

De préférence, le signal codé initial Sd' présente une fréquence fondamentale plus élevée que celle du signal oscillant Se.

De préférence, le signal codé initial Sd' n'est présent qu'en dehors de portions P du signal oscillant Se de longueur prédéfinie, respectivement centrées sur les maximum et les minimum du signal oscillant Se. Ainsi, le signal codé initial Sd' ne risque sensiblement pas d'être déformé du fait des zones de saturations Z+, Z-.

En outre, il sera apprécié que le signal oscillant Se comporte une suite de montées et de descentes. De préférence, le signal codé initial Sd' n'est présent que sur l'un parmi les montées et les descentes (les montées dans l'exemple illustré). Ainsi, comme cela sera expliqué par la suite, l'autre parmi les montées et les descentes peut être utilisé pour la réception de données.

De retour à la figure 2, dans l'exemple décrit, le signal total St est ainsi la somme du signal codé Sd, du signal d'excitation Se et du signal de compensation Sc : St = Se + Sd + Sc = SE + Sc = Sd + K*Se' + Sc.

Pour déterminer le signal de compensation Sc et le coefficient d'asservissement K, le dispositif 118 est en outre conçu pour obtenir un signal de mesure d'une grandeur du dispositif de couplage sensible à la déformation du signal interne.

Dans l'exemple décrit, la grandeur mesurée est une tension Vm aux bornes de la bobine 216. En effet, cette tension Vm est proportionnelle à la dérivée du flux magnétique total Φ formant le signal interne, ce qui correspond sensiblement à un filtrage passe haut. Pour mesurer la tension Vm, le dispositif 218 comporte, dans l'exemple décrit, un convertisseur analogique-numérique 226 pour recevoir la tension Vm en entrée pour la convertir en signal de mesure Sm. Ce dernier présente ainsi une fréquence fondamentale égale à celle du signal oscillant Se.

En cas de déformation résultant du courant auxiliaire I0, un deuxième harmonique apparaît dans le signal Sm.

Ainsi, le dispositif 218 comporte en outre un module 228 d'extraction d'une amplitude du deuxième harmonique du signal mesuré Sm. Ce module d'extraction 228 comporte par exemple un multiplieur conçu pour multiplier le signal de mesure Sm avec une horloge H2 synchronisée sur le deuxième harmonique, suivi d'un filtre passe bas.

En outre, le dispositif 218 est conçu pour fixer le signal de compensation Sc à partir de l'amplitude du deuxième harmonique du signal de mesure Sm pour annuler la déformation, c'est-à-dire de sorte que le flux magnétique de compensation Φc compense le flux magnétique de courant Φ0. Ainsi, cette compensation permet donc d'annuler la déformation du flux magnétique total Φ. Dans l'exemple décrit, cela signifie que le deuxième harmonique du signal mesuré Sm redevient nul. Pour cela, le dispositif 218 comporte dans l'exemple décrit un module 230 de fixation du signal de compensation Sc à partir de l'amplitude du deuxième harmonique du signal de mesure Sm. Le module de fixation 230 comporte par exemple un régulateur proportionnel-intégral.

Le dispositif 218 comporte en outre un module 232 d'évaluation de courant conçu pour évaluer le courant auxiliaire I0 et donc également le courant d'alimentation I à partir du signal de compensation Sc.

Pour déterminer le coefficient K permettant au flux magnétique d'excitation ΦE d'atteindre les deux zones de saturations Z+, Z-, le dispositif 218 utilise la propriété selon laquelle, en choisissant judicieusement le rapport entre les amplitudes des sinusoïdes du signal oscillant Se à la fréquence fondamentale et au troisième harmonique, le troisième harmonique du signal de mesure Sm s'annule lorsque les zones de saturation Z+, Z- sont atteintes. Ainsi, le dispositif 218 comporte tout d'abord un module 234 d'extraction du troisième harmonique du signal de mesure Sm. Ce module d'extraction 234 comporte par exemple un multiplieur conçu pour multiplier le signal de mesure Sm avec une horloge H3 synchronisée sur le troisième harmonique, suivi d'un filtre passe bas. Ensuite, le dispositif 218 comporte un module 236 de fixation du coefficient K à partir de l'amplitude du troisième harmonique du signal de mesure Sm. Le module de fixation 236 comporte par exemple un régulateur proportionnel-intégral.

Il sera également apprécié que le signal d'excitation SE génère, au travers du dispositif de couplage 210, une tension Vpe au primaire du transformateur 212 (c'est-à-dire sur la branche auxiliaire 208) qui se propage sur la ligne de transmission 118.

Comme expliqué précédemment, le dispositif de surveillance 130 est similaire au dispositif de surveillance 128 et transmet une tension Vpr au primaire du transformateur 212. De préférence, les dispositifs de surveillance 128, 130 sont synchronisés l'un avec l'autre, par exemple au moyen des signaux d'horloge transmis avec les signaux codés Sd émis par chacun des dispositifs de surveillance 128, 130. Cette synchronisation permet aux dispositifs de surveillance 128, 130 de créer une onde stationnaire dans la ligne de transmission 118 de sorte que les tensions Vpe et Vpr se superposent l'une à l'autre de manière stationnaire.

Ainsi, la tension mesurée Vm est représentative de cette superposition stationnaire, de même que le signal mesuré Sm.

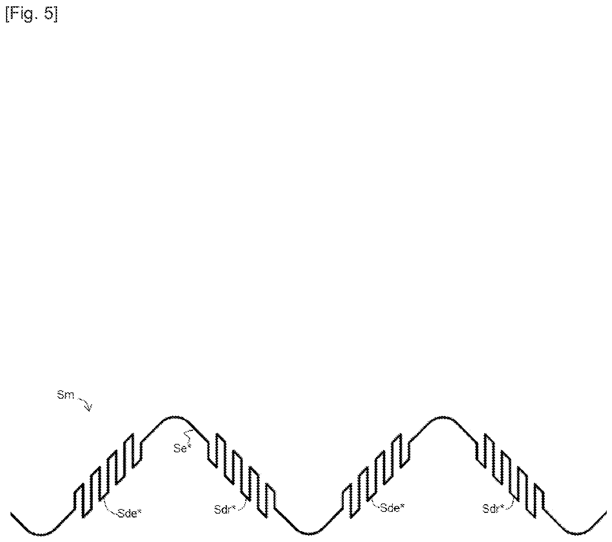

En référence à la figure 5, le signal de mesure Sm comporte donc la somme d'un signal périodique Se*, d'un signal codé émis Sde* et d'un signal codé reçu Sdr*.

Le signal périodique Se* résulte des signaux d'excitation Se des deux dispositifs de surveillance 128, 130. Ce signal périodique Se* est, dans l'exemple décrit, sensiblement triangulaire avec les pointes arrondies car, d'une part, le transformateur 212 joue le rôle d'un dérivateur ce qui transforme les signaux d'excitation Se et, d'autre part, les pointes arrondies résultent des effets de saturation du transformateur 122 détaillés plus haut.

Le signal codé émis Sde* résulte du signal codé Sd émis par le dispositif de surveillance 128, tandis que le signal codé reçu Sdr* résulte du signal codé Sd émis par le dispositif de surveillance 130. Ces signaux codés émis Sde*et reçu Sdr* sont, dans l'exemple décrit, en créneaux du fait du rôle dérivateur du transformateur 212 qui transforme les dents de scie des signaux codé Sd en créneaux.

De retour à la figure 2, il sera apprécié que le signal de mesure Sm est sensible à la présence d'un défaut sur la ligne de transmission 118. En effet, lorsque le capteur de courant 202 fonctionne la compensation du flux magnétique de courant est effective, de sorte que tout se passe dans le dispositif de couplage 210 sensiblement comme si le courant auxiliaire I0 et le signal de compensation étaient nuls. Le noyau 214 n'est parcouru que par le flux magnétique d'excitation, qui s'étend sensiblement dans la zone linéaire entre les deux zones de saturation Z+, Z-. Ainsi, la tension secondaire Vm et le courant i se retrouvent au primaire (à un rapport près) et donc sur la branche auxiliaire 208, ce qui crée un signal se propageant sur la ligne de transmission 118. Du fait que le signal d'excitation SE comporte le signal codé Sd, le signal se propageant inclut les données Tx à transmettre, qui peuvent ainsi atteindre l'autre système de surveillance 130. En outre, tous les éléments connectés au primaire du transformateur 212, et en particulier la ligne de transmission 118, définissent une impédance d'entrée du transformateur 212. En cas de défaut sur la ligne de transmission 118, l'impédance d'entrée du transformateur est modifiée, ce qui entraîne une modification de la tension primaire, et donc de la tension secondaire Vm.

Cette propriété est mise à profit pour détecter un défaut sur la ligne de transmission 118. Le dispositif 218 est ainsi en outre conçu pour analyser le signal de mesure Sm correspondant à la tension secondaire Vm et pour détecter, à partir de cette analyse, un défaut sur la ligne de transmission 118.

Pour cela, l'analyse du signal de mesure Sm comporte en particulier une comparaison du signal de mesure Sm avec au moins un gabarit et la détection du défaut sur la ligne de transmission 118 est réalisée à partir de parties du signal de mesure Sm en dehors d'au moins un parmi le ou les gabarits.

Dans l'exemple décrit, deux gabarits sont utilisés.

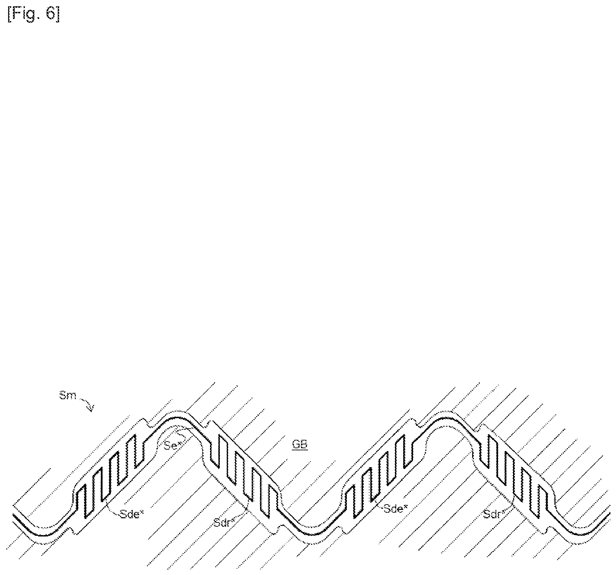

En référence à la figure 6, un gabarit global GB est tout d'abord utilisé, par exemple pour détecter des décharges partielles et d'arcs électriques (de l'anglais « arc tracking ») dans la ligne de transmission 118. Ce gabarit global GB suit, au-dessus et/ou en dessous, des variations du signal oscillant Se* et d'une enveloppe des signaux codés Sde*, Sdr*.

De retour à la figure 2, le dispositif 218 comporte ainsi un module 238 de comparaison du signal de mesure Sm avec le gabarit global GB. Chaque instant où le signal de mesure Sm sort de ce gabarit global GB est enregistré dans un accumulateur 240. Dans le cadre d'un traitement numérique où le signal de mesure Sm est échantillonné, ces instants sont ceux des échantillons dont les valeurs sont en dehors du gabarit global GB.

Le dispositif 218 comporte alors un module d'analyse statistique 242 conçu pour réaliser une analyse statistique des instants de sortie du gabarit global GB accumulés pour détecter un défaut sur la ligne de transmission 118. Cette détection est indiquée par la référence D1 sur la figure 2. Ainsi, lorsque les instants de sortie du gabarit global GB sont trop nombreux, alors le module d'analyse statistique 242 en déduit la présence d'un problème sur la ligne, en particulier d'une décharge partielle et/ou d'un arc électrique. Par exemple, les sorties du gabarit global GB sont considérées trop nombreuses, lorsque, dans un intervalle prédéfini, un ratio entre une durée cumulée de ces sorties du gabarit global GB et une durée totale de l'intervalle, est supérieur à un seuil prédéfini. Ce seuil est par exemple compris entre 2% et 10%, par exemple 5%. Dans l'exemple décrit où les traitements sont numériques, le module d'analyse statistique 242 compte par exemple le nombre d'échantillons du signal de mesure Sm dans l'intervalle prédéfini qui sont en dehors du gabarit global GB, calcule le ratio de ce nombre d'échantillons comptés et du nombre total d'échantillons dans l'intervalle et compare ce ratio au seuil prédéfini.

Le module d'analyse statistique 242 peut en outre être conçu pour analyser une évolution au cours du temps d'un spectre fréquentiel du signal de mesure Sm. Plus précisément, le module d'analyse statistique 242 est conçu pour rechercher un pic de haute fréquence et pour déterminer son amplitude et sa durée. En effet, un arc électrique va produire un pic haute fréquence de grande amplitude persistant dans le temps. Au contraire, une décharge partielle produit un pic haute fréquence de faible amplitude et bref. Ainsi, lorsqu'un pic haute fréquence est trouvé, un problème sur la ligne est détecté. En outre, en fonction de l'amplitude et de la durée de ce pic haute tension, le module d'analyse statistique 242 distingue entre une décharge partielle et un arc électrique. Par exemple, lorsque l'amplitude et la durée du pic haute fréquence sont inférieures à des seuils respectifs prédéfinis, une décharge partielle est détectée, tandis que lorsque l'amplitude et la durée du pic haute fréquence sont respectivement supérieures à ces seuils, un arc électrique est détecté. La fréquence du pic recherché dépend des caractéristiques intrinsèques de la ligne et des éléments d'extrémités. Généralement, le pic sera recherche dans les fréquences au-delà de 10 MHz. De préférence, la recherche sera limitée aux fréquences en dessous de 100 MHz car les atténuations au-delà de 100 MHz sont généralement trop importantes et donc non significatives. Ainsi, la recherche du pic est par exemple réalisée dans l'intervalle 10 MHz - 100 MHz ou bien dans un ou plusieurs intervalles compris dans l'intervalle 10 MHz - 100 MHz.

De préférence, le module d'analyse statistique 242 est conçu pour analyser une récurrence de ce ou ces pics hautes fréquences anormaux trouvés. En effet, au début de leur apparition, les phénomènes sont généralement très transitoires, caractéristiques de perturbations temporaires et sans impact opérationnel. En revanche, si la récurrence satisfait une condition indiquant qu'elle devient trop fréquente (par exemple, lorsque la récurrence passe sous un seuil prédéfini), des problèmes sur la liaison, voire une défaillance de cette dernière, risquent d'intervenir prochainement. Ainsi, une alerte est de préférence générée par le module d'analyse statistique 242 dans ce cas. Cette alerte est par exemple destinée à être affichée sur un écran ou par un voyant lumineux. Le seuil prédéfini de récurrence est par exemple compris entre 2 et 10 détections de pic par heure de fonctionnement de la ligne de transmission.

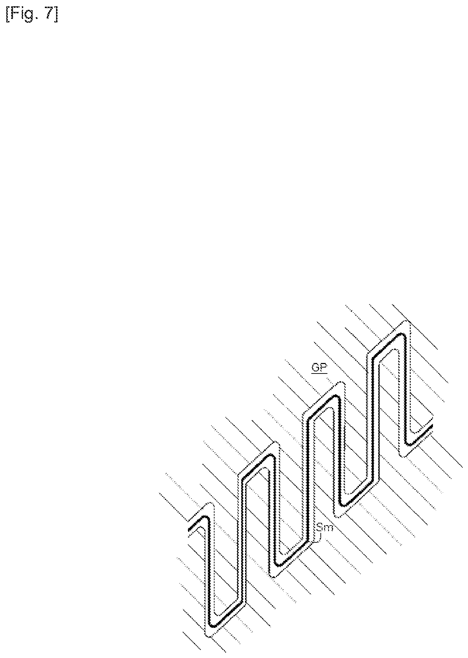

En référence à la figure 7, un gabarit précis GP est en outre utilisé. Ce gabarit précis GP suit, au-dessus et/ou en dessous, les variations des signaux de données Sde*, Sdr*. Il est donc de préférence établi en temps réel en fonction des données émises Tx et reçues Rx.

De retour à la figure 2, le dispositif 218 comporte ainsi un module 244 de comparaison du signal de mesure Sm avec le gabarit précis GP. Chaque instant où le signal de mesure Sm sort de ce gabarit précis GP est enregistré dans un accumulateur 246. Ainsi, les instants de sortie sont représentatifs d'une dispersion d'amplitude du signal de mesure Sm. Dans le cadre d'un traitement numérique où le signal de mesure Sm est échantillonné, ces instants sont ceux des échantillons du signal de mesure Sm dont les valeurs sont en dehors du gabarit précis GP.

Le dispositif 218 comporte alors un module d'analyse statistique 248 conçu pour réaliser une analyse statistique des instants de sortie du gabarit précis GP accumulés pour détecter un défaut sur la ligne de transmission 118. Cette détection est indiquée par la référence D2 sur la figure 2.

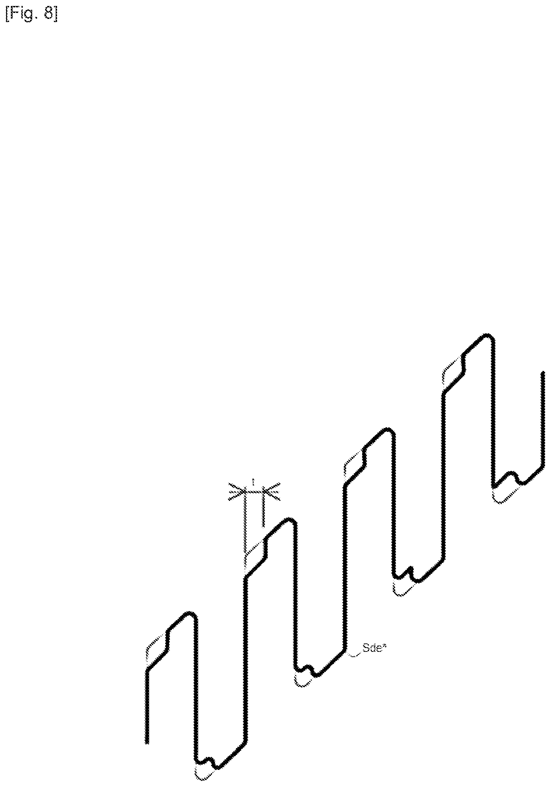

En référence à la figure 8, le module d'analyse statistique 248 est par exemple en outre conçu pour détecter une dégradation du blindage 124 du câble coaxial.

En effet, si le blindage 124 est détérioré localement, le signal se propageant rencontre en ce point une impédance différente de l'impédance caractéristique normale du câble coaxial. Selon que l'impédance rencontrée est plus élevée ou plus faible que l'impédance caractéristique normale, le signal sera amplifié ou atténué sur une partie d'un palier du signal codé Sde* ou Sdr*. Ainsi, cette partie sera décalée par rapport au reste du palier. Ainsi, le module 248 peut être conçu pour déterminer la présence de cette partie décalée et pour déterminer la longueur (c'est-à-dire la durée t) de cette partie décalée. Si le module 248 détecte la présence de partie décalée, il peut alors être conçu pour localiser le long de la ligne de transmission 118 le défaut à partir de la durée t, et de caractéristiques connues de la ligne de transmission 118.

De retour à la figure 2, il sera en outre apprécié que le signal de mesure Sm comporte une suite de montées et de descentes correspondant respectivement aux montées et descentes du signal oscillant Se. Ainsi, dans l'exemple décrit, le dispositif de traitement de données 218 comporte en outre un module 250 de décodage du signal codé Sdr* présent sur l'autre parmi les montées et les descentes du signal de mesure Sm. Ce signal codé Sdr* comporte des données Rx venant du système de surveillance 130 qui est identique au système de surveillance 128.

Ainsi, les systèmes de surveillance 128, 130 peuvent échanger des données.

De préférence, les mêmes mesures (courant et/ou défaut de la ligne de transmission) sont réalisées de manière identique et simultanée à chaque extrémité de la ligne de transmission, par les systèmes de surveillance respectifs 128, 130. Les systèmes de surveillance 128, 130 communiquent alors entre eux, si bien qu'il est possible de communiquer aux organes centraux de l'aéronef, un état global et redondé de la ligne de transmission concernée. En cas d'écart entre les deux mesures, le système peut être décrété en défaut et mis hors service, isolé du reste du système de distribution électrique.

Toujours en référence à la figure 2, le dispositif 218 comporte un module 252 d'analyse du signal de mesure Sm pour détecter une dégradation de l'isolant 122 du câble coaxial. Cette détection est notée D3 sur la figure 2.

En effet, en référence à la figure 8, les portions du signal de mesure Sm comportant le signal codé Sdr* présentent normalement des fronts montants et descendants provenant de la forme en créneaux de ce signal codé Sdr*. Ces fronts montants et descendants présentent ainsi des temps de montée tm et de descente td très courts. Or, avec une dégradation de l'isolant 122, les temps de montée tm et de descente td augmentent. Ainsi, le module d'analyse statistique 248 est conçu pour déterminer et suivre l'évolution des temps de montée tm et descente td pour en déduire une dégradation de l'isolant 122 avec le temps, autrement dit un vieillissement du câble, qui a des répercussions sur les caractéristiques diélectriques du câble. En particulier, les pertes haute fréquence risquent d'augmenter.

L'accumulation des déterminations des temps de montée tm et descente td durant la vie du câble coaxial permet de suivre le vieillissement du câble et d'en mesurer la vitesse.

Le module d'analyse 252 peut être conçu pour comparer ces temps de montée tm et descente td à des seuils respectifs prédéfinis permettant de déterminer, en cas de dépassement, le moment à partir duquel il sera prudent de remplacer la ligne de transmission 118.

Les causes de dégradation de l'isolant de câble sont multiples et peuvent résulter, par exemple, des hautes températures de fonctionnement.

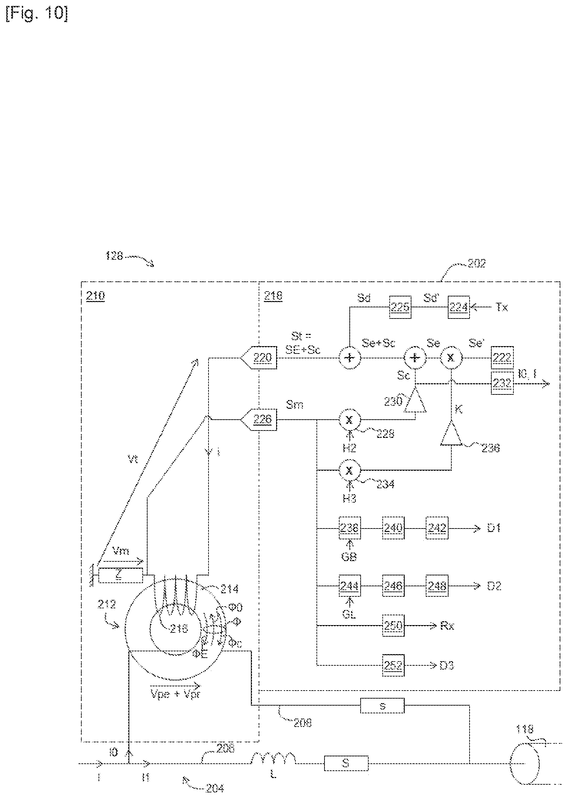

En référence à la figure 10, un autre exemple de mise en œuvre du système de surveillance 128 va à présent être décrit. Le système de surveillance 130 peut aussi être selon cette variante.

Le système de surveillance 128 de la figure 10 est similaire à celui de la figure 2, si ce n'est que l'impédance Z est connectée entre la première extrémité de la bobine 216 et la masse électrique. En outre, dans ce mode de réalisation, la tension Vm est mesurée aux bornes de l'impédance Z. La tension Vm est ainsi proportionnelle à l'intégrale du flux magnétique total Φ formant le signal interne, ce qui correspond sensiblement à un filtrage passe bas. Ainsi, la conversion analogique numérique par le convertisseur 226 est facilitée, le spectre de fréquence associé étant naturellement limité aux basses fréquences.

Il apparaît clairement qu'un système de surveillance selon l'invention permet de mesurer le courant de la ligne de transmission, ainsi que de détecter un défaut de cette ligne de transmission.

On notera par ailleurs que l'invention n'est pas limitée aux modes de réalisation décrits ci-dessus et fournis à titre d'exemple. Elle englobe diverses modifications, formes alternatives ou autre variantes que pourra envisager l'homme du métier, dans le cadre de l'invention.

Par exemple, les modules d'analyse 242, 248 pourraient utiliser des méthodes d'autoapprentissage et d'intelligence artificielle à partir des données intrinsèques obtenues.

Ces modules pourraient en outre être conçus pour recevoir et utiliser d'autres données telles que des températures environnementales, des paramètres de pression (ou d'altitude), des niveaux de vibrations, ainsi que tout autre paramètre susceptible d'influencer la santé de la ligne de transmission surveillée.

Dans la présentation détaillée de l'invention qui est faite précédemment, les termes utilisés ne doivent pas être interprétés comme limitant l'invention aux modes de réalisation exposés dans la présente description, mais doivent être interprétés pour y inclure tous les modes de réalisation selon les revendications annexées.

## Revendications

1. Système (128) de surveillance d'une ligne de transmission (118) connectée à une borne positive (+) d'une source de tension continue (102) par une connexion positive (104) et à une borne négative (-) de la source de tension continue (102) par une connexion négative (106), comportant :
- un dispositif de couplage (210) connecté à la connexion positive (104), mais pas à la connexion négative (106), pour recevoir un courant à mesurer (I0) acheminé par la ligne de transmission (118) et provenant de la borne positive (+) de la source de tension continue (102) ; et
- un dispositif de traitement de données (218) connecté au dispositif de couplage (210) et conçu pour :
• fournir un signal d'excitation (SE) au dispositif de couplage (210) pour qu'un signal interne (Φ) apparaisse dans le dispositif de couplage (210), ce signal interne (Φ) présentant une déformation résultant du courant à mesurer (I0),
• obtenir un signal de mesure (Sm) d'une grandeur (Vm) du dispositif de couplage (210) sensible à la déformation du signal interne (Φ),
• fournir un signal de compensation (Sc) au dispositif de couplage (210) à partir du signal de mesure (Sm) pour annuler la déformation, et
• évaluer le courant à mesurer (I0) à partir du signal de compensation (Sc) ;
**caractérisé en ce que**, le signal de mesure (Sm) étant en outre sensible à la présence d'un défaut sur la ligne de transmission (118), le dispositif de traitement de données (218) est en outre conçu pour analyser le signal de mesure (Sm) et pour détecter, à partir de cette analyse, un défaut sur la ligne de transmission (118).

2. Système selon la revendication 1, dans lequel le dispositif de couplage comporte un transformateur (212) avec un noyau ferromagnétique (214), le signal interne étant un flux magnétique total (Φ) présent dans le noyau (214) et regroupant un flux magnétique d'excitation (ΦE) résultant du signal d'excitation (SE), un flux magnétique de courant (Φ0) résultant du courant à mesurer (I0) et un flux magnétique de compensation (Φc) résultant du signal de compensation (Sc) de manière à sensiblement annuler le flux magnétique de courant (Φ0).

3. Système selon la revendication 1 ou 2, dans lequel l'analyse du signal de mesure (Sm) comporte de comparer le signal de mesure (Sm) avec au moins un gabarit (GB, GP) et dans lequel la détection du défaut sur la ligne de transmission (118) est réalisée à partir d'instants où le signal de mesure (Sm) est en dehors d'au moins un parmi le ou les gabarits (GB, GP).

4. Système selon l'une quelconque des revendications 1 à 3, dans lequel le signal d'excitation (SE) comporte un signal oscillant (Se).

5. Système selon la revendication 4, dans lequel le signal oscillant (Se) comporte une somme d'une sinusoïde à une fréquence fondamentale et d'une sinusoïde au troisième harmonique, c'est-à-dire à trois fois la fréquence fondamentale.

6. Système selon l'une quelconque des revendications 1 à 5, dans lequel, le signal d'excitation (SE) générant, au travers du dispositif de couplage (210), un signal se propageant sur la ligne de transmission (118), le dispositif de traitement de données (218) est en outre conçu pour coder des données à transmettre (Tx) en un signal codé (Sd), par exemple de moyenne nulle et/ou présentant une fréquence fondamentale plus élevée que celle du signal oscillant (Se), et dans lequel le signal d'excitation (SE) comporte le signal codé (Sd) afin que le signal se propageant inclut les données (Tx) à transmettre.

7. Système selon les revendications et 6, dans lequel le au moins un gabarit comporte un gabarit global (GB) qui suit, d'une part, des variations d'un signal oscillant (Se*) du signal de mesure (Sm) résultant du signal oscillant (Se) du signal d'excitation (SE) et, d'autre part, une enveloppe d'un signal codé (Sde*) du signal de mesure (Sm) résultant du signal codé (Sd) du signal d'excitation (SE), le au moins un gabarit comportant par exemple un gabarit local (GP) suivant des variations d'un signal codé (Sde*) du signal de mesure (Sm) résultant du signal codé (Sd) du signal d'excitation (SE).

8. Système selon la revendication 6 ou 7, dans lequel le signal oscillant (Se) comporte une suite de montées et de descentes et dans lequel le signal codé (Sd) n'est présent que sur l'un parmi les montés et les descentes.

9. Système selon la revendication 8, dans lequel le signal de mesure (Sm) comporte une suite de montées et de descentes correspondant respectivement aux montées et descentes du signal oscillant (Se) et dans lequel le dispositif de traitement de données (218) est en outre conçu pour décoder un signal codé présent sur l'autre parmi les montées et les descentes du signal de mesure (Sm).

10. Système selon l'une quelconque des revendications 1 à 9, dans lequel la ligne de transmission (118) est un câble coaxial.

11. Système (100) de distribution électrique comportant :
- une source électrique ;
- une charge électrique ;
- une ligne à transmission connectant la charge électrique à la source électrique, afin que la source électrique alimente électriquement la charge électrique ;
- un système de surveillance de la ligne à transmission, selon l'une quelconque des revendications 1 à 10.

12. Système de distribution électrique selon la revendication 11, dans lequel la source électrique est une source de tension continue, de préférence supérieure à 100 V.

13. Aéronef comportant un système de distribution électrique selon la revendication 11 ou 12.

14. Procédé (128) de surveillance d'une ligne de transmission (118) connectée à une borne positive (+) d'une source de tension continue (102) par une connexion positive (104) et à une borne négative (-) de la source de tension continue (102) par une connexion négative (106), comportant un capteur de courant (202) comportant un dispositif de couplage (210) connecté à la connexion positive (104), mais pas à la connexion négative (106), pour recevoir un courant à mesurer (I0) acheminé par la ligne de transmission (118) et provenant de la borne positive (+) de la source de tension continue (102), comportant :
- fournir un signal d'excitation (SE) au dispositif de couplage (210) pour qu'un signal interne (Φ) apparaisse dans le dispositif de couplage (210), ce signal interne (Φ) présentant une déformation résultant du courant à mesurer (I0),
- obtenir un signal de mesure (Sm) d'une grandeur (Vm) du dispositif de couplage (210) sensible à la déformation du signal interne (Φ),
- fournir un signal de compensation (Sc) au dispositif de couplage (210) à partir du signal de mesure (Sm) pour annuler la déformation ; et
- évaluer le courant à mesurer (I0) à partir du signal de compensation (Sc) ;
**caractérisé en ce que**, le signal de mesure (Sm) étant en outre sensible à la présence d'un défaut sur la ligne de transmission (118), le procédé comporte en outre l'analyse le signal de mesure (Sm) et la détection, à partir de cette analyse, d'un défaut sur la ligne de transmission (118).

15. Programme d'ordinateur téléchargeable depuis un réseau de communication et/ou enregistré sur un support lisible par ordinateur, **caractérisé en ce qu'**il comprend des instructions pour l'exécution des étapes d'un procédé selon la revendications 14, lorsque ledit programme est exécuté sur un système selon la revendication 1.

## Patentansprüche

1. System (128) zur Überwachung einer Übertragungsleitung (118), die über einen positiven Anschluss (104) mit einem positiven (+) Pol einer Gleichspannungsquelle (102) und über einen negativen Anschluss (106) mit einem negativen (-) Pol der Gleichspannungsquelle (102) verbunden ist, umfassend:
- eine Kopplungsvorrichtung (210), die mit dem positiven Anschluss (104), jedoch nicht mit dem negativen Anschluss (106) verbunden ist, um einen zu messenden Strom (I0) aufzunehmen, der über die Übertragungsleitung (118) zugeführt wird und vom positiven (+) Pol der Gleichstromquelle (102) stammt; und
- eine Datenverarbeitungsvorrichtung (218), die mit der Kopplungsvorrichtung (210) verbunden ist und ausgebildet ist zum:
- Bereitstellen eines Anregungssignals (SE) an die Kopplungsvorrichtung (210), damit ein inneres Signal (Φ) in der Kopplungsvorrichtung (210) erscheint, wobei dieses innere Signal (Φ) eine Verformung darstellt, die aus dem zu messenden Strom (I0) resultiert,
- Erhalten eines Messsignals (Sm) einer Größe (Vm) von der Kopplungsvorrichtung (210), das auf die Verformung des inneren Signals (Φ) anspricht,
- Bereitstellen eines Kompensationssignals (Sc) an die Kopplungsvorrichtung (210) ausgehend von dem Messsignal (Sm), um die Verformung aufzuheben, und
- Bewerten des zu messenden Stroms (10) ausgehend von dem Kompensationssignal (Sc);
**dadurch gekennzeichnet, dass** das Messsignal (Sm) weiter auf das Vorhandensein eines Ausfalls auf der Übertragungsleitung (118) anspricht, wobei die Datenverarbeitungsvorrichtung (218) weiter dazu ausgebildet ist, das Messsignal (Sm) zu analysieren und um ausgehend von dieser Analyse einen Ausfall auf der Übertragungsleitung (118) zu erfassen.

2. System nach Anspruch 1, wobei die Kopplungsvorrichtung einen Transformator (212) mit einem ferromagnetischen Kern (214) umfasst, wobei das innere Signal ein Gesamtmagnetfluss (Φ) ist, der im Kern (214) vorhanden ist und einen Anregungsmagnetfluss (ΦE), der aus dem Anregungssignal (SE) resultiert, einen Strommagnetfluss (Φ0), der aus dem zu messenden Strom (10) resultiert, und einen Kompensationsmagnetfluss (Φc), der aus dem Kompensationssignal (Sc) resultiert, so gruppiert, dass der Strommagnetfluss (Φ0) im Wesentlichen aufgehoben wird.

3. System nach Anspruch 1 oder 2, wobei die Analyse des Messsignals (Sm) umfasst, das Messsignal (Sm) mit mindestens einer Vorlage (GB, GP) zu vergleichen und wobei die Erfassung des Ausfalls auf der Übertragungsleitung (118) ab Zeitpunkten durchgeführt wird, in denen das Messsignal (Sm) außerhalb mindestens einer aus der oder den Vorlagen (GB, GP) fällt.

4. System nach einem der Ansprüche 1 bis 3, wobei das Anregungssignal (SE) ein oszillierendes Signal (Se) umfasst.

5. System nach Anspruch 4, wobei das oszillierende Signal (Se) eine Summe aus einer Sinuskurve bei einer Grundfrequenz und einer Sinuskurve bei der dritten Harmonischen, das heißt dem Dreifachen der Grundfrequenz, umfasst.

6. System nach einem der Ansprüche 1 bis 5, wobei das Anregungssignal (SE) durch die Kopplungsvorrichtung (210) ein Signal erzeugt, das sich auf der Übertragungsleitung (118) ausbreitet, wobei die Datenverarbeitungsvorrichtung (218) weiter ausgebildet ist, um zu übertragende Daten (Tx) in ein codiertes Signal (Sd) zu codieren, beispielsweise mit einem Mittelwert von Null und/oder das eine höhere Grundfrequenz als die des oszillierenden Signals (Se) aufweist, und wobei das Anregungssignal (SE) das codierte Signal (Sd) umfasst, sodass das sich ausbreitende Signal die zu übertragenden Daten (Tx) einschließt.

7. System nach einem der Ansprüche 3 und 6, wobei die mindestens eine Vorlage eine globale Vorlage (GB) umfasst, die einerseits Schwankungen eines oszillierenden Signals (Se*) des Messsignals (Sm), das aus dem oszillierenden Signal (Se) des Anregungssignals (SE) resultiert, und andererseits einer Hülle eines codierten Signals (Sde*) des Messsignals (Sm) folgt, das aus dem codierten Signal (Sd) des Anregungssignals (SE) resultiert, wobei die mindestens eine Vorlage zum Beispiel eine lokale Vorlage (GP) umfasst, die Schwankungen eines codierten Signals (Sde*) des Messsignals (Sm) folgt, das aus dem codierten Signal (Sd) des Anregungssignals (SE) resultiert.

8. System nach Anspruch 6 oder 7, wobei das oszillierende Signal (Se) eine Folge von Anstiegen und Abfällen umfasst und wobei das codierte Signal (Se) nur auf einem unter den Anstiegen und Abfällen vorhanden ist.

9. System nach Anspruch 8, wobei das Messsignal (Sm) eine Folge von Anstiegen und Abfällen umfasst, die den Anstiegen bzw. Abfällen des oszillierenden Signals (Se) entsprechen, und wobei die Datenverarbeitungsvorrichtung (218) weiter ausgebildet ist, um ein codiertes Signal zu decodieren, auf das dem anderen unter den Anstiegen und Abfällen des Messsignals (Sm) vorhanden ist.

10. System nach einem der Ansprüche 1 bis 9, wobei die Übertragungsleitung (118) ein koaxiales Kabel ist.

11. System (100) zur Stromverteilung, umfassend:
- eine Stromquelle;
- eine elektrische Ladung;
- eine Übertragungsleitung, die die elektrische Ladung mit der Stromquelle verbindet, damit die Stromquelle die elektrische Ladung mit Strom versorgt;
- ein Überwachungssystem der Übertragungsleitung nach einem der Ansprüche 1 bis 10.

12. System zur Stromverteilung nach Anspruch 11, wobei die Stromquelle eine Gleichspannungsquelle ist, vorzugsweise größer als 100 V.

13. Luftfahrzeug, umfassend ein System zur Stromverteilung nach Anspruch 11 oder 12.

14. Verfahren (128) zur Überwachung einer Übertragungsleitung (118), die über einen positiven Anschluss (104) mit einem positiven (+) Pol einer Gleichspannungsquelle (102) und über einen negativen Anschluss (106) mit einem negativen (-) Pol der Gleichspannungsquelle (102) verbunden ist, umfassend einen Stromsensor (202), der eine Kopplungsvorrichtung (210) umfasst, die mit dem positiven Anschluss (104), jedoch nicht mit dem negativen Anschluss (106) verbunden ist, um einen zu messenden Strom (I0) aufzunehmen, der über die Übertragungsleitung (118) zugeführt wird und vom positiven (+) Pol der Gleichstromquelle (102) stammt, umfassend:
- Bereitstellen eines Anregungssignals (SE) an die Kopplungsvorrichtung (210), damit ein inneres Signal (Φ) in der Kopplungsvorrichtung (210) erscheint, wobei dieses innere Signal (Φ) eine Verformung darstellt, die aus dem zu messenden Strom (I0) resultiert,
- Erhalten eines Messsignals (Sm) einer Größe (Vm) von der Kopplungsvorrichtung (210), das auf die Verformung des inneren Signals (Φ) anspricht,
- Bereitstellen eines Kompensationssignals (Sc) an die Kopplungsvorrichtung (210) ausgehend von dem Messsignal (Sm), um die Verformung aufzuheben; und
- Bewerten des zu messenden Stroms (10) ausgehend von dem Kompensationssignal (Sc);
**dadurch gekennzeichnet, dass** das Messsignal (Sm) weiter auf das Vorhandensein eines Ausfalls auf der Übertragungsleitung (118) anspricht, wobei das Verfahren weiter die Analyse des Messsignals (Sm) und die Erfassung, ausgehend von dieser Analyse, eines Ausfalls auf der Übertragungsleitung (118) umfasst.

15. Computerprogramm, das von einem Kommunikationsnetzwerk aus herunterladbar ist und/oder auf einem computerlesbaren Träger aufgezeichnet ist, **dadurch gekennzeichnet, dass** es Anweisungen für die Ausführung der Schritte eines Verfahrens nach Anspruch 14, wenn das Programm auf einem System nach Anspruch 1 ausgeführt wird, umfasst.

## Claims

1. A system (128) for monitoring a transmission line (118) connected to a positive terminal (+) of a DC voltage source (102) by a positive connection (104) and to a negative terminal (-) of the DC voltage source (102) by a negative connection (106), comprising:
- a coupling device (210) connected to the positive connection (104), but not to the negative connection (106), to receive a current to be measured (10) conveyed by the transmission line (118) and originating from the positive terminal (+) of the DC voltage source (102); and
- a data processing device (218) connected to the coupling device (210) and designed for:
• supplying an excitation signal (SE) to the coupling device (210) so that an internal signal (Φ) appears in the coupling device (210), this internal signal (Φ) having a deformation resulting from the current to be measured (10),
• obtaining a signal (Sm) for measuring a variable (Vm) of the coupling device (210) sensitive to the deformation of the internal signal (Φ),
• supplying a compensation signal (Sc) to the coupling device (210) from the measurement signal (Sm) to cancel the deformation, and
• evaluating the current to be measured (10) from the compensation signal (Sc);
**characterised in that**, the measurement signal (Sm) being additionally sensitive to the presence of a fault on the transmission line (118), the data processing device (218) is additionally designed to analyse the measurement signal (Sm) and to detect, from this analysis, a fault on the transmission line (118).

2. The system according to claim 1, wherein the coupling device comprises a transformer (212) with a ferromagnetic core (214), the internal signal being a total magnetic flux (Φ) present in the core(214) and grouping together an excitation magnetic flux (ΦE) resulting from the excitation signal (SE), a current magnetic flux (Φ0) resulting from the current to be measured (I0) and a compensation magnetic flux (Φc) resulting from the compensation signal (Sc) so as to substantially cancel the current magnetic flux (Φ0).

3. The system according to claim 1 or 2, wherein the analysis of the measurement signal (Sm) comprises comparing the measurement signal (Sm) with at least one template (GB, GP) and wherein the detection of the fault on the transmission line (118) is carried out from instants at which the measurement signal (Sm) is outside at least one of the template or templates (GB, GP).

4. The system according to any one of claims 1 to 3, wherein the excitation signal (SE) comprises an oscillating signal (Se).

5. The system as claimed in claim 4, wherein the oscillating signal (Se) comprises a sum of a sinusoid at a fundamental frequency and a sinusoid at the third harmonic, i.e. at three times the fundamental frequency.

6. The system according to any one of claims 1 to 5, wherein, the excitation signal (SE) generating, through the coupling device (210), a signal propagating on the transmission line (118), the data processing device (218) is further designed to encode data to be transmitted (Tx) into an encoded signal (Sd), for example with a mean of zero and/or having a higher fundamental frequency than that of the oscillating signal (Se), and wherein the excitation signal (SE) comprises the encoded signal (Sd) so that the propagating signal includes the data (Tx) to be transmitted.

7. The system according to claims 3 and 6, wherein the at least one template comprises a global template (GB) which tracks, on the one hand, variations of an oscillating signal (Se*) of the measurement signal (Sm) resulting from the oscillating signal (Se) of the excitation signal (SE) and, on the other hand, an envelope of an encoded signal (Sde*) of the measurement signal (Sm) resulting from the encoded signal (Sd) of the excitation signal (SE), the at least one template comprising for example a local template (GP) tracking variations of an encoded signal (Sde*) of the measurement signal (Sm) resulting from the encoded signal (Sd) of the excitation signal (SE).

8. The system according to any one of claims 6 or 7, wherein the oscillating signal (Se) comprises a sequence of rises and falls and wherein the encoded signal (Sd) is present only on one of the rises and the falls.

9. The system according to claim 8, wherein the measurement signal (Sm) comprises a sequence of rises and falls corresponding respectively to the rises and falls of the oscillating signal (Se) and wherein the data processing device (218) is further designed to decode an encoded signal present on the other of the rises and the falls of the measurement signal (Sm).

10. The system according to any one of claims 1 to 9, wherein the transmission line (118) is a coaxial cable.

11. An electrical distribution system (100) comprising:
- an electrical source;
- an electrical load;
- a transmission line connecting the electrical load to the electrical source, so that the electrical source supplies electrical power to the electrical load;
- a system for monitoring the transmission line according to any one of claims 1 to 10.

12. The electrical distribution system as claimed in claim 11, wherein the electrical source is a DC voltage source, preferably greater than 100 V.

13. An aircraft comprising an electrical distribution system according to claim 11 or 12.

14. A method (128) for monitoring a transmission line (118) connected to a positive terminal (+) of a DC voltage source (102) by a positive connection (104) and to a negative terminal (-) of the DC voltage source (102) by a negative connection (106), comprising a current sensor (202) comprising a coupling device (210) connected to the positive connection (104), but not to the negative connection (106), for receiving a current to be measured (I0) conveyed by the transmission line (118) and originating from the positive terminal (+) of the DC voltage source (102), comprising:
- supplying an excitation signal (SE) to the coupling device (210) so that an internal signal (Φ) appears in the coupling device (210), this internal signal (Φ) having a deformation resulting from the current to be measured (10),
- obtaining a signal (Sm) for measuring a variable (Vm) of the coupling device (210) sensitive to the deformation of the internal signal (Φ),
- supplying a compensation signal (Sc) to the coupling device (210) from the measurement signal (Sm) to cancel the deformation; and
- evaluating the current to be measured (I0) from the compensation signal (Sc);
**characterised in that**, the measurement signal (Sm) being further sensitive to the presence of a fault on the transmission line (118), the method further comprises analysing the measurement signal (Sm) and detecting, from this analysis, a fault on the transmission line (118).

15. A computer program downloadable from a communication network and/or stored on a computer-readable medium, **characterised in that** it comprises instructions for executing the steps of a method according to claim 14, when said program is executed in a system according to claim 1.
